# EUROPEAN PATENT SPECIFICATION

(11) **EP 2 034 488 B1**
(45) Date of publication and mention of the grant of the patent: **06.11.2013**
(21) Application number: 07017612.8
(22) Date of filing: 07.09.2007
(51) Int. Cl.: G11C 7/10, G11C 8/12, G06F 9/50

(54) **Method to improve the performance of memory operations**
Verfahren zur Verbesserung der Leistung von Speicheroperationen
Procédé d'amélioration de la performance des fonctions de mémoire

(43) Date of publication of application: 11.03.2009
(73) Proprietor: Nokia Siemens Networks Oy, 02610 Espoo (FI)
(72) Inventor: Hazay, Alon, 62917 Tel Aviv (IL); Shirizly, Dekel, Pardes Hana (IL)
(74) Representative: Bruglachner, Thomas E.

(56) References cited:
- US-A- 5 835 952
- US-A1- 2003 198 119
- US-A1- 2005 018 521

## Description

The invention is related to a method to improve the speed of memory operations on specific memory locations in a dynamic random access memory, which is organized in memory banks that can be accessed quasi in parallel.

Dynamic Random Access Memories DRAM are memory devices which are low cost compared to static Random Access Memories SRAM and are used widely in electronic systems. They are also built much denser (bit per device). The performance limitation of DRAM lies in the speed of memory operations, especially in read-modify-write operations. DRAM need a latency time of several clock cycles between an address clock cycle and a clock cycle for read or write. This latency time is not required by SRAM and so SRAM is used in time critical applications.

US 2003/0198119 A1 discusses DRAMs which enable execution of a read and a write command on a single clock cycle.

An example for timing critical applications is packet processing in network elements in packet networks, such as in switches or routers. In packet processing the most challenging memory operation is read-modify-write, which occurs in many tasks like policing or statistics.

To perform such tasks efficiently, often SRAM is used in the network elements, which adds cost to these elements.

It is the objective of this invention to improve the performance of time critical memory operations in DRAM.

This is achieved by the method of claim 1.

Embodiments of the invention are shown in the dependent claims.

The proposed method is used in applications, which require a high performance on memory operations and where SRAM was used to satisfy this requirement. Now DRAM can be used to perform memory operations with a timing comparable to SRAM.

DRAM is organised in memory banks, which can be accessed quasi in parallel. A first memory bank is addressed and a number of predefined clock cycles have to pass to cover the latency time of the memory. Directly after the addressing of the first memory bank, the second memory bank can be addressed and the latency times then run in parallel. When the first latency time has passed, the read or write operation takes place and directly afterwards, the read or write operation on the second bank can be executed. This quasi parallel operation makes memory accesses in different banks comparable to operations in SRAM.

The specific memory locations, on which the time critical operations are executed, are arranged in a first memory bank of the DRAM and a second memory bank is allocated to the first memory bank. Write operations are executed alternatively to the specific memory location in the first and the second memory bank.

An often used time critical memory operation is the read-modify-write operation. With this method the read operation is executed on the specific memory location in the first memory bank, the read value is modified and written back into the corresponding specific memory location in the second memory bank. With the next read-modify-write operation on the same specific memory location, first the location in the second bank is read and the modified value is written back into the first memory bank.

A toggle bit is associated with each specific memory location and toggled with each write operation to coordinate the operations in that way that they execute on the valid memory location in the first or second memory bank. It indicates if the valid memory location is either in the first or second memory bank.

The read-modify-write operation is a typical operation for counters. The value of the counter is read, it is incremented and the new value is written back into the memory location of this counter.

But it is emphasized that this method is not limited only to counters but can be applied to other time critical applications.

This described method improves the performance of memory operations in DRAM. The drawback of a second memory bank and an additional toggle bit to each specific memory location is not relevant in the light of the much less cost of DRAM compared to SRAM. Also the density of DRAM is much higher than SRAM and so the used space for the devices is lower.

The figures depict the timing of the memory operations.
Fig. 1 shows the timing of SRAM and DRAM.
Fig. 2 shows the quasi parallel operation in DRAM.

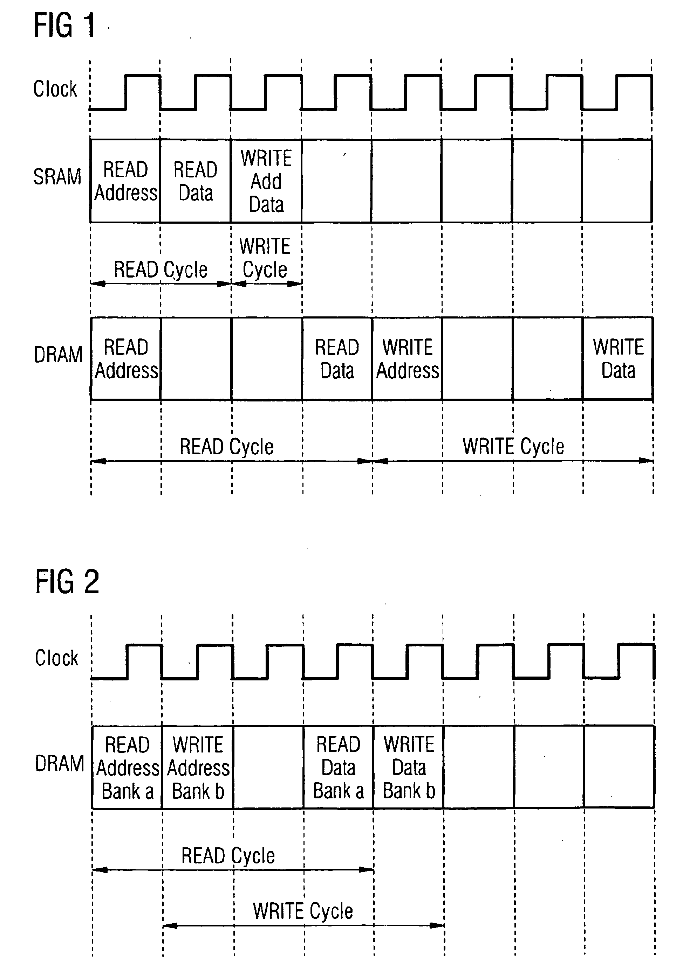

Fig. 1 shows the basic READ and WRITE cycles of SRAM and RAM. Each access has an address cycle and data cycle. In SRAM a READ operation requires an address cycle and then with the next clock the data is read. A WRITE operation takes one clock cycle, the address and data are applied the same time. So, for a read-modify write operation, it takes three clock cycles.

In DRAM the data cycle of READ or WRITE requires a latency time of several clock cycles after applying the address. This latency time is depending on the DRAM type and the clock speed. Here a latency time of two clock cycles is assumed. So, when doing a read-modify-write operation on one memory location in the same memory bank with DRAM in the conventional way, it will take much more time than with SRAM. This restricts the use of DRAM in some time critical applications.

In Fig. 2 the same READ and WRITE cycle on one memory location stored in two different memory banks a and b is shown.

The address cycle for the READ operation is made to bank a. The next clock, the address cycle for WRITE is made to bank b. After the latency time, here two clock cycles, the information from bank a is read. The modified data can be written the next clock cycle to bank b.

By this, a read-modify-write operation is also completed in two clock cycles.The next time, the information should be read from bank b and not from bank a.In order to know which bank contains the valid information, a toggle bit is associated with each memory location and is toggled each time data is written into the specific memory location.

## Claims

1. A method to improve the speed of memory operations on specific memory locations in a dynamic random access memory, which is organized in memory banks of which a second memory bank (Bank b) can be addressed after a first memory bank (Bank a)has been addressed and before the first memory bank (Bank a) returns a requested date, **characterized in that** a specific memory location of the second memory bank (Bank b)is associated with a specific memory location of the first memory bank (Bank a) and that write operations onto the specific memory location of the first and the second memory banks (Bank a, Bank b) use the associated memory banks (Bank a, Bank b) alternatively by sequentially carrying out steps of :
- addressing the specific memory location of a first one of the first or second memory banks (Bank a, Bank b) for a read access,
- addressing the specific memory location of a remaining one of the first or second memory banks (Bank a, Bank b) for a write access,
- reading the requested date returned by the first one of the first or second memory banks (Bank a, Bank b),
- modifying the requested date,
- writing the modified requested date to the remaining one of the first or second memory banks (Bank a, Bank b), and
- repeating the steps exchanging the first memory bank (Bank a) and the second memory bank (Bank b).
the specific memory location is used for read-modify-write operations.
the access is achieved by addressing the specific memory location in the memory bank (Bank a, Bank b) and perform a read or write operation after a predefined number of clock cycles, which corresponds to a latency time.

2. The method according to claim 1, **characterized in that** addressing the specific memory location of the remaining one of the first and the second memory banks (Bank a, Bank b) is performed one clock cycle after addressing the first one of the first or the second memory banks (Bank a, Bank b).

3. The method according to one of the claims 1 or 2, **characterized in that** a toggle bit is associated with the specific memory location.

4. The method according to claim 3, **characterized in that** the toggle bit indicates the memory bank (Bank a, Bank b) with the valid specific memory location.

5. The method according to claim 3, **characterized in that** the toggle bit is toggled after each write operation.

6. The method according to claim 1, **characterized in that** the specific memory location contains a counter.

## Patentansprüche

1. Verfahren zur automatisierten Netzwerktopologieerkennung in passiven optischen Netzwerken, in denen ein optischer Leitungsabschluss (OLT - Optical Line Terminal, 10) über mehrere optische Splitter mit mehreren optischen Netzwerkeinheiten (ONUs, 21 bis 25) verbunden ist, wobei das Verfahren für jede der ONUs Folgendes beinhaltet:
- Einkoppeln eines optischen Impulses in das passive optische Netzwerk;
- Messen der Leistung des reflektierten Lichts und
- Übertragung von Messdaten umfassend eine Entfernungsinformation über eine Entfernung der ONU von einem oder mehreren der optischen Splitter (31, 32) von dem OLT.

2. Verfahren nach Anspruch 1, weiterhin umfassend einen Schritt des Detektierens eines oder mehrerer Wendepunkte in einer Bahn des gemessenen reflektierten Lichts.

3. Verfahren nach Anspruch 2, wobei mindestens eine erste der ONUs (21 bis 25) den Schritt des Detektierens eines oder mehrerer Wendepunkte ausführt und eine Information über eine Position des einen oder der mehreren Wendepunkte innerhalb der Bahn zu dem OLT (10) als die Entfernungsinformationen überträgt.

4. Verfahren nach den Ansprüchen 2 oder 3, wobei mindestens eine zweite der ONUs (21 bis 25) die Bahn als die Entfernungsinformationen überträgt und wobei der OLT (10) den Schritt des Detektierens des einen oder der mehreren Wendepunkte und des Bestimmens der Position des einen oder der mehreren Wendepunkte innerhalb der Bahn ausführt.

5. Verfahren nach einem der Ansprüche 3 oder 4, weiterhin mit der Verarbeitung der Positionen der einen oder mehreren Wendepunkte von jeder ONU (21 bis 25) und gegenseitiges gemeinsames Gruppieren von ONUs mit einem ersten Wendepunkt zu einer oder mehreren jeweiligen Gruppen.

6. Verfahren nach Anspruch 5, weiterhin mit dem Unterteilen der jeweiligen Gruppe oder der jeweiligen Gruppen von ONUs (21 bis 25) in eine oder mehrere erste Untergruppen, wobei alle ONUs der Untergruppe den ersten und einen jeweiligen zweiten Wendepunkt gegenseitig gemeinsam haben.

## Revendications

1. Un procédé de découverte automatisée de topologie de réseau dans des réseaux optiques passifs dans lesquels un terminal de ligne optique (OLT, 10) est raccordé à une pluralité d'unités de réseau optique (ONU, 21 à 25) par l'intermédiaire d'une pluralité de diviseurs optiques, le procédé comprenant pour chacune des ONU :
- le lancement d'une impulsion optique dans le réseau optique passif,
- la mesure d'une puissance de lumière réfléchie, et
- la transmission de données de mesure comprenant une information de distance relative à une distance de l'ONU à un ou plusieurs des diviseurs optiques (31, 32) à l'OLT.

2. Le procédé selon la revendication 1, comprenant en outre une étape de détection d'un ou plusieurs points d'inflexion dans un tracé de la lumière réfléchie mesurée.

3. Le procédé selon la revendication 2, dans lequel au moins une première des ONU (21 à 25) exécute l'étape de détection d'un ou de plusieurs points d'inflexion et transmet une information relative à une position des un ou plusieurs points d'inflexion à l'intérieur du tracé à l'OLT (10) en tant qu'information de distance.

4. Le procédé selon les revendications 2 ou 3, dans lequel au moins une deuxième des ONU (21 à 25) transmet le tracé en tant qu'information de distance et dans lequel l'OLT (10) exécute l'étape de détection des un ou plusieurs points d'inflexion et de détermination de la position des un ou plusieurs points d'inflexion à l'intérieur du tracé.

5. Le procédé selon l'une quelconque des revendications 3 ou 4, comprenant en outre le traitement des positions des un ou plusieurs points d'inflexion provenant de chaque ONU (21 à 25) et le groupement des ONU possédant un premier point d'inflexion mutuellement en commun en un ou plusieurs groupes respectifs.

6. Le procédé selon la revendication 5, comprenant en outre la subdivision du groupe respectif ou des groupes respectifs d'ONU (21 à 25) en un ou plusieurs premiers sous-groupes, toutes les ONU du sous-groupe possédant mutuellement en commun le premier et un deuxième point d'inflexion respectif.
